# EUROPEAN PATENT SPECIFICATION

(11) **EP 1 260 862 B1**
(45) Date of publication and mention of the grant of the patent: **11.04.2012**
(21) Application number: 02253475.4
(22) Date of filing: 17.05.2002
(51) Int. Cl.: G03F 1/24

(54) **Lithographic apparatus, device manufacturing methods, method of manufacturing a reflector and phase shift mask**
Lithographisches Gerät, Methoden zur Herstellung von Bauelementen, Methode zur Herstellung eines Reflektors sowie eine Phasenschiebermaske
Appareil lithographique, méthodes pour fabriquer des éléments, méthode pour fabriquer un réflecteur ainsi qu'un masque à décalage de phase

(30) Priority: 21.05.2001 EP 01304452
(43) Date of publication of application: 27.11.2002
(73) Proprietor: ASML Netherlands B.V., 5504 DR Veldhoven (NL)
(72) Inventor: Singh, Mandeep, Twickenham, Middlesex TW2 7NR (GB); Braat, Josephus Johannes Maria, 2627 CA Delft (NL)
(74) Representative: Slenders, Petrus J. W.

(56) References cited:
- EP-A- 0 708 367
- EP-A- 1 152 435
- US-A- 5 338 647
- US-A- 5 399 448
- US-A- 6 159 643
- PATENT ABSTRACTS OF JAPAN vol. 2000, no. 02, 29 February 2000 (2000-02-29) & JP 11 305417 A (HITACHI LTD), 5 November 1999 (1999-11-05)

## Description

The present invention relates to a lithographic projection apparatus comprising:
- a radiation system for supplying a projection beam of radiation;
- a support structure for supporting patterning means, the patterning means serving to pattern the projection beam according to a desired pattern;
- a substrate table for holding a substrate; and
- a projection system for projecting the patterned beam onto a target portion of the substrate.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. An example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. The required matrix addressing can be performed using suitable electronic means. More information on such mirror arrays can be gleaned, for example, from United States Patents US 5,296,891 and US 5,523,193, . In the case of a programmable mirror array, the said support structure may be embodied as a frame or table, for example, which may be fixed or movable as required.
- A programmable LCD array. An example of such a construction is given in United States Patent US 5,229,872. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (*e.g.* comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus ― commonly referred to as a step-and-scan apparatus ― each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792.

In a manufacturing process using a lithographic projection apparatus, a pattern (*e.g.* in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, *e.g.* an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4 .

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Twin stage lithographic apparatus are described, for example, in US 5,969,441 and WO 98/40791.

In order to meet the continual demand of manufactures of semiconductor devices to be able to produce ever smaller features, it has been proposed to use Extreme Ultraviolet (EUV) radiation, *e.g.* with a wavelength of 5 to 20 nm, as the exposure radiation in a lithographic projection apparatus. Not least among the problems in designing such an apparatus is the creation of "optical" systems to illuminate evenly the patterning means and to project the image of the pattern defined by the patterning means accurately onto the substrate. Part of the difficulties in producing the necessary illumination and optical systems lies in the fact that no material suitable for making refractive optical elements at EUV wavelengths is presently known. Thus, the illumination and projection systems must be constructed out of mirrors which, at EUV wavelengths, have their own problems - specifically relatively low reflectivities and extremely high sensitivity to figure errors.

It is essential in a lithographic projection apparatus that the mirrors have high reflectivities since the illumination and projection systems may have a total of eight mirrors so that, with the additional reflection at the mask, the overall transmissivity of the systems is proportional to the ninth power of the reflectivity of the mirrors. To provide mirrors of sufficiently high reflectivity, it has been proposed to use mirrors formed by multilayer stacks of materials such as Mo, Si, Rh, Ru, Rb, Cl, Sr and Be. Further details of such multilayer stacks are given in European Patent Applications EP-A-1 065 532 and EP-A-1 065 568.

Projection systems using mirrors are particularly sensitive to figure errors at EUV wavelengths because a figure error of only 3nm would give rise to an error in the wavefront of about π radians, leading to destructive interference and making the reflector totally useless for imaging. Figure errors may have a variety of causes: errors in the surface of the substrate on which the multilayers are deposited, defects in the multilayers, stresses in the multilayer resulting from the manufacturing process, etc.. To correct such phase errors, it is proposed in WO97/33203 to add selectively a relatively thick additional layer of crystalline or amorphous Si to the front surface of a reflector formed by a multilayer stack of Mo/Si. However, an additional layer locally reduces the reflectivity of the mirror, which may cause non-uniform illumination or exposure in lithographic projection apparatus. EP-0 708 367-A discloses the use of a relatively thick layer having attenuation and phase shifting functions locally deposited on a multilayer stack to form a mask pattern.

It is an object of the present invention to provide improved reflectors useable with EUV radiation that have reduced figure errors and adequate reflectivity.

This and other objects are achieved according to the invention in a lithographic apparatus as specified in the opening paragraph, characterized in that at least one of the radiation system, the projection system and the patterning means comprises a reflector provided with a multilayer stack comprising a plurality of base periods and at least one additional period covering only part of the effective area of said reflector to effect a local change in phase and/or reflectivity relative to an adjacent area of said reflector upon reflection of said projection beam, wherein the or at least some of said additional periods are formed of materials different than the materials of said base periods, characterised in that the or each additional period comprises a first layer of a first material selected from the group comprising Rh, Pd, Pt and Ru.

By providing additional periods on top of the existing multilayer, desired phase and/or reflectivity corrections, *e.g.* to compensate for the effects of figure errors in the multilayer or underlying substrate, can be effected with a smaller effect on reflectivity. With the invention, it is possible to correct both "valley-like" (a local depression in the multilayer, e.g. caused by a depression in the substrate) and "hill-like" (a local projection in the multilayer) figure errors. The additional periods are provided in a pattern that is the negative of the figure errors, i.e. additional periods are provided in the valley of a valley-like figure error and additional periods are substantially provided around but not over the hill-like figure error.

The additional periods are made of different materials as the underlying multilayer stack, , *e.g.* Ru/Si or Ru-Mo/Si on an Mo/Si stack. Preferably, the thicknesses of said additional layers are optimized to provide an appropriate trade-off between phase shift to extreme ultraviolet radiation as compared to a vacuum layer of thickness equal to the total thickness of said additional layers, and total reflectivity.

Each of the additional periods has a total thickness such that the path length of the radiation through it (in one direction) is about half a wavelength. In other words the total thickness is somewhat less than half a wavelength dependent on the angle of incidence of the radiation to be reflected. For maximum reflectivity the path length should be exactly half a wavelength but may be varied from this to affect a desired reflectivity change. For EUV radiation of wavelength of about 5 to 20 nm, the additional periods will each have a thickness less than about 10nm, compared to thicknesses of several hundreds of nm in prior art arrangements.

According to a further aspect of the invention there is provided a device manufacturing method comprising the steps as disclosed in claims 11 and 12.

Further, the invention provides a method of manufacturing a reflector for use in the radiation or illumination systems of a lithographic projection apparatus, the method comprising the steps as disclosed in claim 13.

Still further the invention provides a phase shift mask for use in lithographic projection, as disclosed in claim 14.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range 5-20 nm).

Embodiments of the invention will now be described, by way of example only, with reference to the accompanying schematic drawings in which:
Figure 1 depicts a lithographic projection apparatus according to an embodiment of the invention;
Figure 2 illustrates a reflector used in the first embodiment of the invention;
Figure 3 is a graph of phase shift and reflectivity vs. total thickness for additional Mo/Si layers;
Figure 4 is a graph of phase shift vs. total thickness for additional layers of various different combinations of materials.
Figure 5 illustrates a phase shift mask according to a second embodiment of the invention; and
Figure 6 is a graph of phase shift vs. total thickness for two mulitlayer stacks used in the phase shift mask of the second embodiment.
In the Figures, corresponding reference symbols indicate corresponding parts.

### Embodiment 1

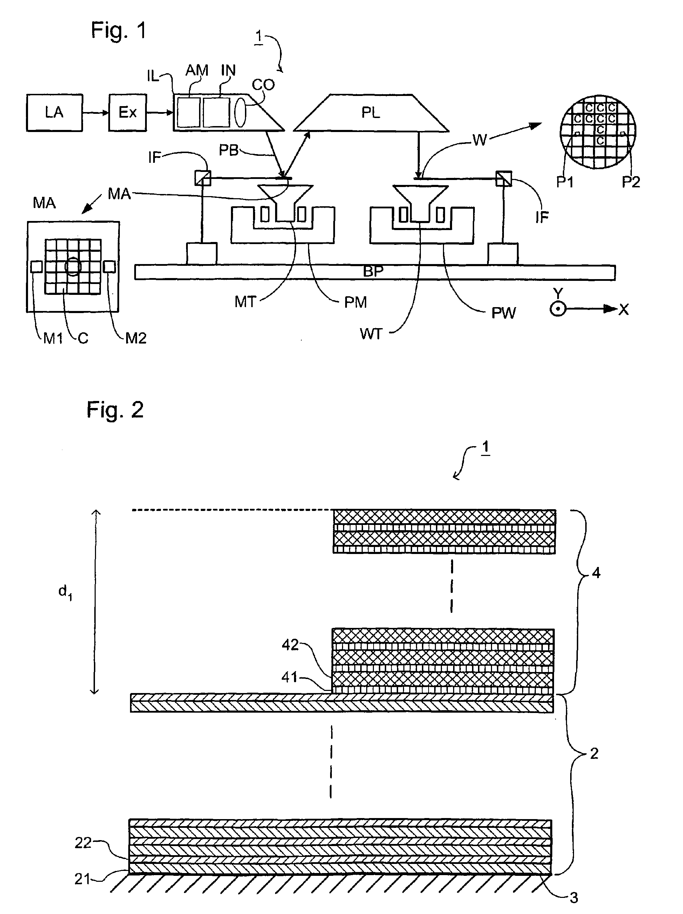

Figure 1 schematically depicts a lithographic projection apparatus according to a particular embodiment of the invention. The apparatus comprises:
· a radiation system Ex, IL, for supplying a projection beam PB of radiation (*e.g.* EUV radiation). In this particular case, the radiation system also comprises a radiation source LA;
· a first object table (mask table) MT provided with a mask holder for holding a mask MA (*e.g.* a reticle), and connected to first positioning means for accurately positioning the mask with respect to item PL;
· a second object table (substrate table) WT provided with a substrate holder for holding a substrate W (*e.g.* a resist-coated silicon wafer), and connected to second positioning means for accurately positioning the substrate with respect to item PL;
· a projection system ("lens") PL *(e.g.* a mirror group) for imaging an irradiated portion of the mask MA onto a target portion C *(e.g.* comprising one or more dies) of the substrate W.

As here depicted, the apparatus is of a reflective type (*i.e.* has a reflective mask). However, in general, it may also be of a transmissive type, for example (with a transmissive mask). Alternatively, the apparatus may employ another kind of patterning means, such as a programmable mirror array of a type as referred to above.

The source LA (*e.g.* a laser-produced or discharge plasma source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (*e.g.* with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having been selectively reflected by the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:
1. In step mode, the mask table MT is kept essentially stationary, and an entire mask image is projected in one go (*i.e.* a single "flash") onto a target portion C. The substrate table WT is then shifted in the x and/or y directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", *e.g.* the y direction) with a speed *v*, so that the projection beam PB is caused to scan over a mask image; concurrently, the substrate table WT is simultaneously moved in the same or opposite direction at a speed *V = Mv*, in which *M* is the magnification of the lens PL (typically, *M* = 1/4 or 1/5). In this manner, a relatively large target portion C can be exposed, without having to compromise on resolution.

Figure 2 shows a reflector 1 used in the first embodiment of the invention. The reflector 1 comprises a multilayer stack 2, *e.g.* comprising alternating layers of Molybdenum 21 and Silicon 22, grown on a substrate 4. To correct figure errors in the multilayer reflector, *e.g.* deriving from figure errors in the substrate 3 or from defects in the manufacture of the multilayer stack 2, additional multilayers 4 are added locally, as necessary to provide the desired correction. As a comparative example, the additional multilayers 4 may be made of alternating layers 41, 42 of the same materials as the multilayer stack 2, *e.g.* Molybdenum and Silicon, but have their thicknesses, optimized for the desired phase change. Mathematical techniques for optimization of the various layer thicknesses as described in European Patent Applications EP-A-1 065 532 and EP-A-1 065 568 may be used. To determine the figure errors that are to be corrected, interferometric techniques can be used.

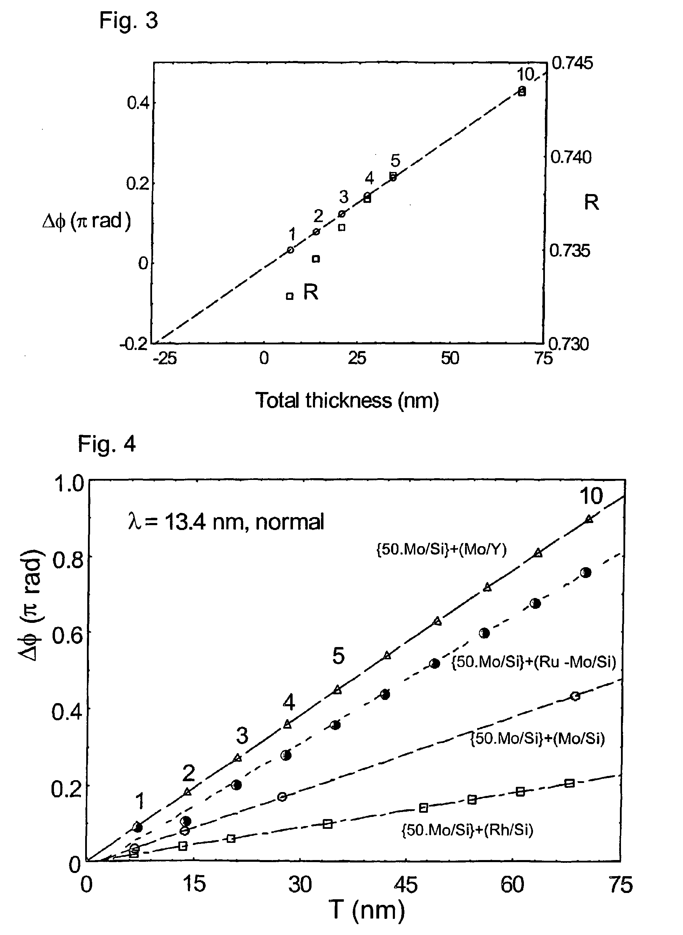

Figure 3 shows the phase change Δϕ (open circles), in units of π radians, achievable for the addition of 1, 2, 3, 4, 5 or 10 periods of Mo/Si as well as resulting increases in reflectivity (open squares). The dashed line is a least squares fit to the phase change values. In the following description the notation x-y/z (with x optional) is used to describe a period of a multilayer stack where y, and optionally x, may be denoted as an absorbing material and z as a spacer material. In addition, for a multilayer with additional periods, the base period is enclosed in {} and the additional layers in (). In general, a multilayer is "tuned" if the total optical thickness (physical thickness multiplied by refractive index) of its period is equal to half the wavelength of the incident radiation, taking into account the angle of incidence as necessary.

As alternatives to the optimized Mo/Si layers, the present invention proposes that Ru can be used in place of or in addition to Mo and Y can be used in place of Si. Figure 4 shows the phase shift Δϕ, in units of π radians, achievable for the addition of 1 to 10 periods of Mo/Y (open triangles), Ru-Mo/Si (filled circles) and Rh/Si (open squares) to a fifty period Mo/Si multilayer. The results of Figure 3 for the addition of optimized Mo/Si layers (open circles) are also shown for comparison. Figure 4 shows that the use of Ru-Mo in place of Mo and Y in place of Si can provide greater phase changes (sensitivities) for the same physical thickness of additional layers. In the Ru-Mo/Si additional layers, the Ru and Mo layer thicknesses were fixed at 2nm but may of course be optimized as desired.

In calculating the number and/or materials of the additional layers, account must be taken of the consequence of the complex refractive index of materials in the EUV region that the phase change on reflection, e.g. at the interface between Mo or Ru and Si layers, deviates from π radians which is expected for the non-absorbing case. For an Mo/Si stack the deviation is about 0.02π radians per period so that a ten-period optimized Mo/Si stack exhibits a 0.43π phase shift, as compared to a 0.62π phase shift that would be expected were there no absorption. It will be seen that the data in Figures 3 and 4 take this effect into account. Further, the values of phase changes of the additional multilayers are given with respect to a hypothetical "vacuum layer" of the same thickness as the added multilayers. The designs presented in Figures 3 and 4 include a final capping layer, whereas the designs of Table 1 do not, giving rise to a slight difference in presented values for comparable designs.

Table 1 below gives calculated phase sensitivities for various multilayer structures wherein multilayers number 3-10 and 12-14 are useable as additional layers in the invention. It will be seen by comparing designs 1 and 2 that the phase sensitivity per period Δε increases form 0.043π to 0.054π as the Mo thickness is deliberately set to 4.0nm. Similarly, Ru/Si designs 3 and 4 exhibit a large change in Δε as the Ru thickness is increased form 1.98nm to 3.50nm (changing the partition ration, i.e. the ratio of the thickness of the absorber and the spacer layers in the multilayer period). This is because of the lower n of Ru compared to Mo but the higher extinction coefficient of Ru means that there is a significant drop in peak reflectivity. The three-component Ru-Mo/Si additional layers maintain high peak reflectivities even as the Ru and Mo thicknesses are increased, with designs 6 and 7 exhibiting particularly high values of Δε. The yttrium-based stacks exhibit the greatest phase sensitivity due to the significant contribution of Y to the phase change with respect to vacuum.

It will also be seen that only small phase sensitivities are exhibited by the Rh/Si, Pd/Si and Pt/Si designs. This means that even a large physical thickness of such additional layers may be deposited yielding a negligible wavefront phase change (with respect to a hypothetical vacuum layer of the same thickness) and such layers may be optionally used as filler layers between the localized additional layers so that the reflector surface is substantially uniform. Note that in designs 13 and 14, the total (optical) thickness of the multilayer structure has been detuned to shift the peak reflectivity to 13.5nm (though the peak reflectivity quoted is at 13.4 nm) to increase the phase change sensitivity by changing the spacer thickness (Y or Si) with respect to designs 12 and 7, respectively.

Any figure error may be corrected by adding additional multilayers at those locations that exhibit a "valley"-like figure error. Another approach is to add the additional multilayers over the whole of the reflective surface and will away some or all of the added multilayers, as required, at those locations that exhibit a "hill"-like figure error. Filler stacks presenting a small or negligible phase change (as will be described in embodiment 2) may be added in between the additional multilayers presenting a large phase change to and up with an approximately level reflective surface.

**Table 1: Phase sensitivity and effective peak reflectivity of various multilayer period structures grown on an optimized 50-period Mo/Si (2.77nm Mo and 4.08nm Si) base multilayer tuned for λ = 13.4 nm operation at normal incidence with a peak reflectivity of 0.748.**

| | **ML period of the form *x-y*/*z*** | **Layer thickness (nm)** | | | **Peak Reflectivity** | | **Δε (π radians)** |
|---|---|---|---|---|---|---|---|
| | | ***x*** | ***y*** | ***z*** | **5 periods** | **10 periods** | |
| **1** | **Mo/Si** | - | 2.68 | 4.17 | 0.749 | 0.749 | 0.043 |
| **2** | **Mo/Si** | - | 4.00 | 2.90 | 0.725 | 0.716 | 0.054 |
| **3** | **Ru/Si** | - | 1.98 | 4.82 | 0.727 | 0.716 | 0.028 |
| **4** | **Ru/Si** | - | 3.50 | 3.40 | 0.678 | 0.658 | 0.080 |
| **5** | **Ru-Mo/Si** | 1.00 | 1.68 | 4.18 | 0.752 | 0.754 | 0.045 |
| **6** | **Ru-Mo/Si** | 1.80 | 1.80 | 3.30 | 0.737 | 0.734 | 0.073 |
| **7** | **Ru-Mo/Si** | 2.00 | 2.00 | 2.93 | 0.723 | 0.715 | 0.090 |
| **8** | **Rh/Si** | - | 1.51 | 5.25 | 0.704 | 0.679 | 0.015 |
| **9** | **Pd/Si** | - | 1.15 | 5.59 | 0.688 | 0.648 | 0.008 |
| **10** | **Pt/Si** | - | 0.87 | 5.85 | 0.678 | 0.625 | 0.003 |
| **11** | **Mo/Y** | - | 2.61 | 4.37 | 0.695 | 0.664 | 0.090 |
| **12** | **Ru-Mo/Y** | 2.00 | 2.00 | 3.06 | 0.685 | 0.639 | 1.109 |
| **13** | **Ru-Mo/Y** | 2.00 | 2.00 | 3.15 | 0.670 | 0.626 | 0.121 |
| **14** | **Ru-Mo/Si** | 2.00 | 2.00 | 3.10 | 0.658 | 0.608 | 0.111 |

### Embodiment 2

The second embodiment of the present invention provides a phase shift mask for use at EUV wavelengths. The phase shift mask can be used in a lithographic apparatus as described with reference to Figure 1, with or without the corrected reflectors described above.

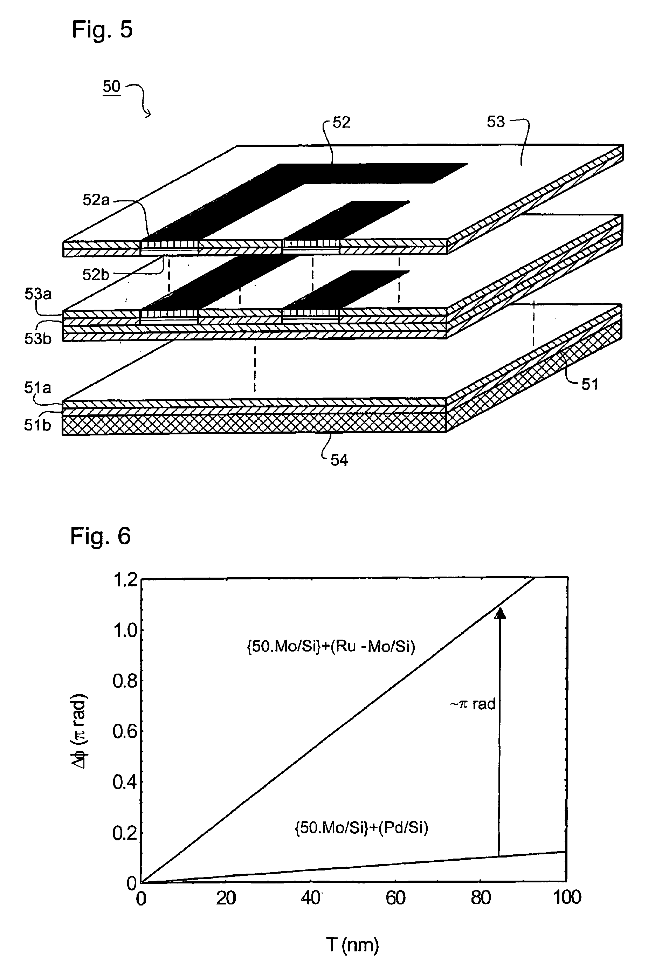

A phase shift reflective mask 50 is shown in Figure 5 of the accompanying drawings. This comprises a base multilayer stack 51 each period of which comprises a layer of absorbing material 51 a and a layer of a spacer material 51b. On top of the base multilayer 51 are selectively provided a phase shifting stack 52, again each period of which comprises a layer of absorbing material 52a and a layer of a spacer material 52b, and a filler stack 53, each period of which also comprises a layer of absorbing material 53a and a layer of a spacer material 53b. The phase shifting stack 52 and filler stack 53 are arranged in a pattern as necessary to pattern the projection beam to cause the desired image to be projected onto the substrate. Design rules for the phase shift mask of the present invention can be adapted as necessary from those employed for phase shift masks at other frequencies.

The phase shift mask of the present embodiment exploits the ability described above to provide multilayer stacks with both large phase sensitivities and small phase sensitivities. A phase shift mask necessitates selectively shifting the optical wavefront by, for instance, π radians. A π radian (or any other value such as π/2) phase change is readily achievable with respect to a "vacuum layer" or with respect to a filler multilayer (e.g. designs 9 and 10 in table 1), albeit at the expense of some reflectivity. As shown in Figure 6, a π phase shift is shown between the a phase shifting stack 52 of Ru-Mo/Si (design 7 in table 1) and a filler stack of Pd/Si (design 9 in table 1) after approximately 11 periods. An advantage of such a phase shift mask with a π-radian phase change with respect to a filler stack is that the surface of the mask may be level to within ∼3 nm.

The additional period(s) of the present invention (especially in the second embodiment) can be used to effect local changes in reflectivity as well as or instead of phase, e.g. by choice of materials, partition ratio and/or period thickness. In a reflector, such changes in reflectivity may be used to compensate for reflectivity errors in the base layers or in another component. In a mask, such reflectivity changes can be used to create partially attenuating mask types.

The description is not intended to limit the invention defined by the appended claims. In particular, the calculations on which the present examples are based employed the optical constants set out in Table 2 below. To design reflectors and masks for use at other wavelengths, or should such constants be determined to be inaccurate, the skilled person can effect appropriate corrections.

**Table 2: Optical constants of the materials referred to above. The complex refractive indices (n - ik) are taken from: B.L. Henke, E.M. Gullikson, and J.C. Davis, "X-ray interactions: photoabsortion, scattering, transmission and reflection at E = 50-30,000 eV, Z = 1-92," At. Data Nucl. Data Tables 54, 181-342 (1993).**

| **Material** | **Optical constants (λ = 13.4 nm)** | |
|---|---|---|
| | ***n*** | ***k*** |
| **Mo** | 0.9227 | 0.0062 |
| **Pd** | 0.8780 | 0.0443 |
| **Pt** | 0.8928 | 0.0577 |
| **Rh** | 0.8775 | 0.0296 |
| **Ru** | 0.8898 | 0.0165 |
| **Si** | 0.9999 | 0.0018 |
| **Y** | 0.9742 | 0.0023 |

## Claims

1. A lithographic projection apparatus comprising:
- a radiation system for providing a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate,
wherein at least one of the radiation system, the projection system and the patterning means comprises a reflector provided with a multilayer stack comprising a plurality of base periods and at least one additional period covering only part of the effective area of said reflector to effect a local change in phase and/or reflectivity relative to an adjacent area of said reflector upon reflection of said projection beam,
wherein the or at least some of said additional periods are formed of materials different than the materials of said base periods,
**characterised in that** the or each additional period comprises a first layer of a first material selected from the group comprising Rh, Pd, Pt and Ru.

2. An apparatus according to claim 1 wherein the or each additional period is grown or deposited to cover substantially all the effective area of said reflector and selectively milled away to uncover said base periods.

3. An apparatus according to claim 1 wherein the or each additional period is selectively grown or deposited after completion of said base periods.

4. An apparatus according to claim 1, 2 or 3 wherein the or each additional period and said base periods comprise alternating layers comprising Mo and Si, respectively.

5. An apparatus according to claim 1 wherein the or each additional period comprises a second layer of a second material selected from the group comprising Si and Y.

6. An apparatus according to claim 1 wherein the or each additional period comprises three layers formed of Ru, Mo and Si respectively.

7. An apparatus according to any one of the preceding claims wherein the or each additional period has a different partition ratio than said base periods.

8. An apparatus according to any one of the preceding claims wherein the or each additional period has a determined thickness to provide a peak reflectivity at a wavelength different than the wavelength of said projection beam.

9. An apparatus according to any one of the preceding claims further comprising at least one filler layer provided on said base periods where said additional period(s) is not provided, said filler layer effecting a different change in phase and/or reflectivity than said additional period(s).

10. An apparatus according to any one of the preceding claims wherein said radiation system is adapted to provide a projection beam of radiation having wavelengths in the range of from 5 to 20nm and said reflector has a reflectance peak encompassing the wavelength of said radiation of said projection beam.

11. A device manufacturing method comprising the steps of:
- providing a substrate that is at least partially covered by a layer of radiation-sensitive material;
- providing a projection beam of radiation using a radiation system; using patterning means to endow the projection beam with a pattern in its cross-section;
- projecting the patterned beam of radiation onto a target portion of the layer of radiation-sensitive material,
wherein
said projection beam or said patterned beam is directed or patterned using a reflector provided with a multilayer stack comprising a plurality of base periods and at least one additional period covering only part of the effective area of said reflector to effect a local change in phase and/or reflectivity relative to an adjacent area of said reflector,
wherein the or at least some of said additional periods are formed of materials different than the materials of said base periods,
**characterised in that** the or each additional period comprises a first layer of a first material selected from the group comprising Rh, Pd, Pt and Ru.

12. The device manufacturing method of claim 11 wherein the reflector is a phase shift mask.

13. A method of manufacturing a reflector for use in the radiation or illumination systems of a lithographic projection apparatus, the method comprising the steps of:
providing a multilayer stack on a substrate, the multilayer stack comprising a plurality of base periods;
determining any figure errors in the multilayer stack or substrate;
selectively providing at least one additional period on the front surface of said multilayer stack to effect a local change in phase and/or reflectivity relative to adjacent areas of said reflector in radiation reflected by said reflector to compensate for the effects of said figure errors,
wherein the or at least some of said additional periods are formed of materials different than the materials of said base periods,
**characterised in that** the or each additional period comprises a first layer of a first material selected from the group comprising Rh, Pd, Pt and Ru.

14. A phase shift mask for use in lithographic projection, said mask comprising a multilayer stack comprising a plurality of base periods and an additional multilayer stack comprising at least one additional period covering only part of the effective area of said mask, whereby said additional period effects a local change in phase and/or reflectivity relative to adjacent areas of said mask on reflection of a projection beam,
wherein the or at least some of said additional periods are formed of materials different than the materials of said base periods,
**characterised in that** the or each additional period comprises a first layer of a first material selected from the group comprising Rh, Pd, Pt and Ru.

15. A phase shift mask according to claim 14 further comprising a filler multilayer stack comprising at least one filler period provided in the regions of said mask where there is no phase-shifting multilayer, said filler multilayer stack effecting a different change in phase and/or reflectivity than said phase-shifting multilayer stack.

16. A phase shift mask according to claim 14 or 15 wherein additional multilayer stack effects a local phase change of substantially pi radians at a wavelength in the range of from 5 to 20nm, relative to said adjacent areas.

## Patentansprüche

1. Ein lithographisches Projektionsgerät, das Folgendes beinhaltet:
- ein Strahlungssystem zum Bereitstellen eines Projektionsstrahls aus Strahlung;
- eine Stützstruktur zum Stützen eines Musteraufbringungsmittels, wobei das Musteraufbringungsmittel dazu dient, den Projektionsstrahl gemäß einem gewünschten Muster zu mustern;
- einen Substrattisch zum Halten eines Substrats;
- ein Projektionssystem zum Projizieren des gemusterten Strahls auf einen Zielabschnitt des Substrats,
wobei mindestens eines von dem Strahlungssystem, dem Projektionssystem und dem Musteraufbringungsmittel einen Reflektor beinhaltet, der mit einem mehrschichtigen Stapel versehen ist, der eine Vielzahl von Basisperioden und mindestens eine zusätzliche Periode, die nur einen Teil des effektiven Bereichs des Reflektors abdeckt, um bei Reflexion des Projektionsstrahls eine örtliche Änderung der Phase und/oder der Reflektivität relativ zu einem benachbarten Bereich des Reflektors zu bewirken, beinhaltet,
wobei die oder mindestens einige der zusätzlichen Perioden aus anderen Materialien als den Materialien der Basisperioden gebildet sind,
**dadurch gekennzeichnet, dass** die oder jede zusätzliche Periode eine erste Schicht aus einem ersten Material beinhaltet, das aus der Gruppe, die Rh, Pd, Pt und Ru beinhaltet, ausgewählt ist.

2. Gerät gemäß Anspruch 1, wobei die oder jede zusätzliche Periode gezüchtet oder abgelagert wird, um im Wesentlichen den gesamten effektiven Bereich des Reflektors abzudecken, und selektiv abgetragen wird, um die Basisperioden freizulegen.

3. Gerät gemäß Anspruch 1, wobei die oder jede zusätzliche Periode nach Fertigstellung der Basisperioden selektiv gezüchtet oder abgelagert wird.

4. Gerät gemäß Anspruch 1, 2 oder 3, wobei die oder jede zusätzliche Periode und die Basisperioden abwechselnde, Mo bzw. Si beinhaltende Schichten beinhalten.

5. Gerät gemäß Anspruch 1, wobei die oder jede zusätzliche Periode eine zweite Schicht aus einem zweiten Material beinhaltet, das aus der Gruppe, die Si und Y beinhaltet, ausgewählt ist.

6. Gerät gemäß Anspruch 1, wobei die oder jede zusätzliche Periode drei Schichten beinhaltet, die aus Ru, Mo bzw. Si gebildet sind.

7. Gerät gemäß einem der vorhergehenden Ansprüche, wobei die oder jede zusätzliche Periode ein anderes Verteilungsverhältnis als die Basisperioden aufweist.

8. Gerät gemäß einem der vorhergehenden Ansprüche, wobei die oder jede zusätzliche Periode eine bestimmte Dicke aufweist, um eine Spitzenreflektivität bei einer anderen Wellenlänge als der Wellenlänge des Projektionsstrahls bereitzustellen.

9. Gerät gemäß einem der vorhergehenden Ansprüche, das ferner mindestens eine Füllerschicht beinhaltet, die auf den Basisperioden bereitgestellt ist, wo die zusätzliche(n) Periode(n) nicht bereitgestellt ist/sind, wobei die Füllerschicht eine andere Änderung der Phase und/oder der Reflektivität als die zusätzliche(n) Periode(n) bewirkt.

10. Gerät gemäß einem der vorhergehenden Ansprüche, wobei das Strahlungssystem angepasst ist, um einen Projektionsstrahl aus Strahlung mit Wellenlängen in der Spanne von 5 bis 20 nm bereitzustellen, und der Reflektor eine Reflexionsgradspitze aufweist, die die Wellenlänge der Strahlung des Projektionsstrahls einschließt.

11. Ein Verfahren zum Herstellen einer Vorrichtung, das die folgenden Schritte beinhaltet:
- Bereitstellen eines Substrats, das mindestens teilweise von einer Schicht aus strahlungsempfindlichem Material abgedeckt ist;
- Bereitstellen eines Projektionsstrahls aus Strahlung unter Verwendung eines Strahlungssystems;
- Verwenden eines Musteraufbringungsmittels, um dem Projektionsstrahl in seinem Querschnitt ein Muster zu geben;
- Projizieren des gemusterten Strahls aus Strahlung auf einen Zielabschnitt der Schicht aus strahlungsempfindlichem Material,
wobei
der Projektionsstrahl oder der gemusterte Strahl unter Verwendung eines Reflektors, der mit einem mehrschichtigen Stapel versehen ist, welcher eine Vielzahl von Basisperioden und mindestens eine zusätzliche Periode, die nur einen Teil des effektiven Bereichs des Reflektors abdeckt, um eine örtliche Änderung der Phase und/oder der Reflektivität relativ zu einem benachbarten Bereich des Reflektors zu bewirken, beinhaltet, gelenkt oder gemustert wird,
wobei die oder mindestens einige der zusätzlichen Perioden aus anderen Materialien als den Materialien der Basisperioden gebildet sind,
**dadurch gekennzeichnet, dass** die oder jede zusätzliche Periode eine erste Schicht aus einem ersten Material beinhaltet, das aus der Gruppe, die Rh, Pd, Pt und Ru beinhaltet, ausgewählt ist.

12. Verfahren zum Herstellen einer Vorrichtung gemäß Anspruch 11, wobei der Reflektor eine Phasenschiebermaske ist.

13. Ein Verfahren zum Herstellen eines Reflektors zur Verwendung in den Strahlungs- oder Beleuchtungssystemen eines lithographischen Projektionsgeräts, wobei das Verfahren die folgenden Schritte beinhaltet:
Bereitstellen eines mehrschichtigen Stapels auf einem Substrat, wobei der mehrschichtige Stapel eine Vielzahl von Basisperioden beinhaltet;
Bestimmen etwaiger Formfehler in dem mehrschichtigen Stapel oder Substrat;
selektives Bereitstellen mindestens einer zusätzlichen Periode auf der vorderen Oberfläche des mehrschichtigen Stapels, um eine örtliche Änderung der Phase und/oder der Reflektivität relativ zu benachbarten Bereichen des Reflektors bei von dem Reflektor reflektierter Strahlung zu bewirken, um die Effekte der Formfehler zu kompensieren,
wobei die oder mindestens einige der zusätzlichen Perioden aus anderen Materialien als den Materialien der Basisperioden gebildet sind,
**dadurch gekennzeichnet, dass** die oder jede zusätzliche Periode eine erste Schicht aus einem ersten Material beinhaltet, das aus der Gruppe, die Rh, Pd, Pt und Ru beinhaltet, ausgewählt ist.

14. Eine Phasenschiebermaske zur Verwendung bei lithographischer Projektion, wobei die Maske einen mehrschichtigen Stapel, der eine Vielzahl von Basisperioden beinhaltet, und einen zusätzlichen mehrschichtigen Stapel, der mindestens eine zusätzliche Periode beinhaltet, die nur einen Teil des effektiven Bereichs der Maske abdeckt, wodurch die zusätzliche Periode eine örtliche Änderung der Phase und/oder der Reflektivität relativ zu benachbarten Bereichen der Maske bei Reflexion eines Projektionsstrahls bewirkt, beinhaltet,
wobei die oder mindestens einige der zusätzlichen Perioden aus anderen Materialien als den Materialien der Basisperioden gebildet sind,
**dadurch gekennzeichnet, dass** die oder jede zusätzliche Periode eine erste Schicht aus einem ersten Material beinhaltet, das aus der Gruppe, die Rh, Pd, Pt und Ru beinhaltet, ausgewählt ist.

15. Phasenschiebermaske gemäß Anspruch 14, die ferner einen mehrschichtigen Füllerstapel beinhaltet, der mindestens eine Füllerperiode beinhaltet, die in den Regionen der Maske bereitgestellt ist, in denen es keine phasenverschiebende Mehrfachschicht gibt, wobei der mehrschichtige Füllerstapel eine andere Änderung der Phase und/oder der Reflektivität als der phasenverschiebende mehrschichtige Stapel bewirkt.

16. Phasenschiebermaske gemäß Anspruch 14 oder 15, wobei der zusätzliche mehrschichtige Stapel eine örtliche Phasenänderung von im Wesentlichen pi Radiant bei einer Wellenlänge in der Spanne von 5 bis 20 nm relativ zu den benachbarten Bereichen bewirkt.

## Revendications

1. Un appareil de projection lithographique comprenant :
- un système de rayonnement pour fournir un faisceau de projection de rayonnement ;
- une structure formant support pour supporter un moyen pour conformer selon un motif, le moyen pour conformer selon un motif servant à conformer le faisceau de projection selon un motif souhaité ;
- une table porte-substrat pour porter un substrat ;
- un système de projection pour projeter le faisceau à motif sur une portion cible du substrat,
dans lequel au moins un élément d'entre le système de rayonnement, le système de projection et le moyen pour conformer selon un motif comprend un réflecteur pourvu d'un empilement multicouche comprenant une pluralité de périodes de base et au moins une période additionnelle ne couvrant qu'une partie de la surface effective dudit réflecteur pour effectuer un changement local de phase et/ou de réflectivité par rapport à une surface adjacente dudit réflecteur lors de la réflexion dudit faisceau de projection,
dans lequel ces dites périodes additionnelles ou certaines d'entre elles au moins sont formées en matériaux différents des matériaux desdites périodes de base, **caractérisé en ce que** la ou chaque période additionnelle comprend une première couche en un premier matériau sélectionné dans le groupe comprenant Rh, Pd, Pt et Ru.

2. Un appareil selon la revendication 1 dans lequel on fait croître ou on dépose la ou chaque période additionnelle afin qu'elle couvre substantiellement l'ensemble de la surface effective dudit réflecteur et on la fraise de manière sélective afin de découvrir lesdites périodes de base.

3. Un appareil selon la revendication 1 dans lequel on fait croître ou on dépose de manière sélective la ou chaque période additionnelle après achèvement desdites périodes de base.

4. Un appareil selon la revendication 1, la revendication 2 ou la revendication 3 dans lequel la ou chaque période additionnelle et lesdites périodes de base comprennent des couches alternées comprenant Mo et Si, respectivement.

5. Un appareil selon la revendication 1 dans lequel la ou chaque période additionnelle comprend une deuxième couche en un deuxième matériau sélectionné dans le groupe comprenant Si et Y.

6. Un appareil selon la revendication 1 dans lequel la ou chaque période additionnelle comprend trois couches formées en Ru, Mo et Si respectivement.

7. Un appareil selon l'une quelconque des revendications précédentes dans lequel la ou chaque période additionnelle a un rapport de partage différent de celui desdites périodes de base.

8. Un appareil selon l'une quelconque des revendications précédentes dans lequel la ou chaque période additionnelle a une épaisseur déterminée afin de fournir une réflectivité de pic à une longueur d'onde différente de la longueur d'onde dudit faisceau de projection.

9. Un appareil selon l'une quelconque des revendications précédentes comprenant en outre au moins une couche de remplissage fournie sur lesdites périodes de base là où la ou lesdites périodes additionnelles ne sont pas fournies, ladite couche de remplissage effectuant un changement de phase et/ou de réflectivité différent de celui de la ou desdites périodes additionnelles.

10. Un appareil selon l'une quelconque des revendications précédentes dans lequel ledit système de rayonnement est conçu pour fournir un faisceau de projection de rayonnement ayant des longueurs d'onde comprises dans la gamme allant de 5 à 20 nm et ledit réflecteur a un pic de réflectance englobant la longueur d'onde dudit rayonnement dudit faisceau de projection.

11. Un procédé de fabrication de dispositif comprenant les étapes consistant à :
- fournir un substrat qui est au moins partiellement couvert d'une couche de matériau sensible au rayonnement ;
- fournir un faisceau de projection de rayonnement à l'aide d'un système de rayonnement ;
- utiliser un moyen pour conformer selon un motif afin de doter le faisceau de projection d'un motif dans sa coupe transversale ;
- projeter le faisceau de rayonnement à motif sur une portion cible de la couche de matériau sensible au rayonnement,
dans lequel
ledit faisceau de projection ou ledit faisceau à motif est dirigé ou conformé selon un motif à l'aide d'un réflecteur pourvu d'un empilement multicouche comprenant une pluralité de périodes de base et au moins une période additionnelle ne couvrant qu'une partie de la surface effective dudit réflecteur pour effectuer un changement local de phase et/ou de réflectivité par rapport à une surface adjacente dudit réflecteur,
dans lequel ces dites périodes additionnelles ou certaines d'entre elles au moins sont formées en matériaux différents des matériaux desdites périodes de base, **caractérisé en ce que** la ou chaque période additionnelle comprend une première couche en un premier matériau sélectionné dans le groupe comprenant Rh, Pd, Pt et Ru.

12. Le procédé de fabrication de dispositif de la revendication 11 dans lequel le réflecteur est un masque à décalage de phase.

13. Un procédé de fabrication d'un réflecteur destiné à être utilisé dans les systèmes de rayonnement ou d'illumination d'un appareil de projection lithographique, le procédé comprenant les étapes consistant à :
fournir un empilement multicouche sur un substrat, l'empilement multicouche comprenant une pluralité de périodes de base ;
déterminer toutes erreurs de forme dans l'empilement multicouche ou le substrat ;
fournir de manière sélective au moins une période additionnelle sur la surface avant dudit empilement multicouche afin d'effectuer un changement local de phase et/ou de réflectivité par rapport à des surfaces adjacentes dudit réflecteur dans un rayonnement réfléchi par ledit réflecteur afin de compenser les effets desdites erreurs de forme,
dans lequel cesdites périodes additionnelles ou certaines d'entre elles au moins sont formées en matériaux différents des matériaux desdites périodes de base,
**caractérisé en ce que** la ou chaque période additionnelle comprend une première couche en un premier matériau sélectionné dans le groupe comprenant Rh, Pd, Pt et Ru.

14. Un masque à décalage de phase destiné à être utilisé en projection lithographique, ledit masque comprenant un empilement multicouche comprenant une pluralité de périodes de base et un empilement multicouche additionnel comprenant au moins une période additionnelle ne couvrant qu'une partie de la surface effective dudit masque, grâce à quoi ladite période additionnelle effectue un changement local de phase et/ou de réflectivité par rapport à des surfaces adjacentes dudit masque lors de la réflexion d'un faisceau de projection,
dans lequel ces dites périodes additionnelles ou certaines d'entre elles au moins sont formées en matériaux différents des matériaux desdites périodes de base, **caractérisé en ce que** la ou chaque période additionnelle comprend une première couche en un premier matériau sélectionné dans le groupe comprenant Rh, Pd, Pt et Ru.

15. Un masque à décalage de phase selon la revendication 14 comprenant en outre un empilement multicouche de remplissage comprenant au moins une période de remplissage prévue dans les régions dudit masque où il n'y a pas de multicouche de décalage de phase, ledit empilement multicouche de remplissage effectuant un changement de phase et/ou de réflectivité différent de celui dudit empilement multicouche de décalage de phase.

16. Un masque à décalage de phase selon la revendication 14 ou la revendication 15 dans lequel l'empilement multicouche additionnel effectue un changement de phase local de substantiellement pi radians à une longueur d'onde comprise dans la gamme allant de 5 à 20 nm, par rapport auxdites surfaces adjacentes.
